# FASCICULE DE BREVET EUROPEEN

(11) **EP 3 149 853 B1**
(45) Date de publication et mention de la délivrance du brevet: **03.07.2019**
(21) Numéro de dépôt: 15727333.5
(22) Date de dépôt: 26.05.2015
(51) Int. Cl.: H03K 17/12, H03K 17/18

(54) **TRANSISTOR A EFFET DE CHAMP ET DISPOSITIF DE DETECTION DE DEFAILLANCE ASSOCIE**
FELDEFFEKTTRANSISTOR UND ZUGEHÖRIGE FEHLERDETEKTIONSVORRICHTUNG
FIELD-EFFECT TRANSISTOR AND ASSOCIATED FAULT DETECTION DEVICE

(30) Priorité: 27.05.2014 FR 1454808
(43) Date de publication de la demande: 05.04.2017
(73) Titulaire: Renault S.A.S., 92100 Boulogne-Billancourt (FR)
(72) Inventeur: TAVERNIER, François, F-42170 St Just St Rambert (FR); PERICHON, Pierre, F-38500 Voiron (FR)
(74) Mandataire: GIE Innovation Competence Group
(86) Numéro de dépôt international: PCT/EP2015/061502
(87) Numéro de publication internationale: WO 2015/181112

(56) Documents cités:
- EP-A1- 2 458 736
- EP-A1- 2 587 670
- EP-A2- 0 730 347
- EP-A2- 1 801 974
- US-A1- 2003 103 306
- US-A1- 2011 193 580
- US-A1- 2012 248 864
- US-B2- 7 847 702

## Description

L'invention concerne les transistors à effet de champ de puissance, et en particulier la détection d'une défaillance en court-circuit d'un transistor à effet de champ normalement ouvert.

De multiples applications font appel à des transistors à effet de champ de puissance de type normalement ouvert utilisés en commutation. Un nombre croissant d'applications fait appel à des sources de tension continue de puissance, par exemple pour la traction automobile. Des transistors nMos de puissance sont fréquemment utilisés pour des fonctions de sécurité, par exemple pour isoler une borne de connexion par rapport à une source de tension. Lorsqu'un tel transistor de puissance est confronté à une défaillance en mode court-circuit, la source de tension peut appliquer un courant de court-circuit atteignant très rapidement une amplitude élevée. Pour éviter l'apparition de défaillances ou d'échauffements graves liés à un tel courant, il s'avère primordial de détecter une défaillance du transistor en un temps très bref pour mettre en oeuvre des mesures de sécurité, notamment pour commander l'ouverture d'autres transistors ou éviter leur fermeture.

Parmi les dispositifs de détection de défaillance connus, aucune solution à coût raisonnable n'a été identifiée pour détecter suffisamment rapidement et de façon fiable une défaillance d'un transistor à effet de champ de puissance.

Le document US7847702 décrit un circuit de détection de défaillances dans des composants intégrés, présentant de faibles niveaux de puissance. Dans de tels composants intégrés, le mode de défaillance par dégradation de l'isolant entre grille et source n'est pas surveillé car il s'agit d'un mode de défaillance rarissime, au contraire d'une défaillance par dégradation de l'isolant entre grille et drain.

Le document US2003/103306 décrit un transistor de puissance normalement ouvert, pour alimenter un moteur électrique. Un circuit de détection vérifie qu'une tension de blocage est appliquée sur la grille du transistor et vérifie simultanément l'apparition d'une tension anormale sur le drain du transistor. Un tel circuit de détection permet uniquement de déterminer un court-circuit entre drain et source.

La publication archivée à l'adresse Internet http://www.microelectronique.univ-rennes1.fr/fr/chap11k.htm explicite la problématique relative aux transistors à effet de champ de puissance de type normalement ouverts. Un transistor à effet de champ de puissance comporte une épaisseur d'isolant entre grille et drain très supérieure à l'épaisseur d'isolant entre grille et source. En effet, l'isolant entre grille et drain est l'isolant qui doit assurer la tenue en tension à l'état bloqué. L'épaisseur d'isolant entre grille et source est plus réduite du fait de l'application d'une différence de potentiel beaucoup plus réduite.

Un autre exemple de dispositif de détection de défaillance d'un transistor de puissance est décrit dans le document EP1801974, dans lequel un courant de fuite entre la grille et la source du transistor lorsque celui-ci est passant est évalué, afin de détecter la destruction d'une couche isolante du transistor, et ainsi d'anticiper un court-circuit entre la source et le drain.

L'invention vise à résoudre un ou plusieurs de ces inconvénients. L'invention vise en particulier à détecter précocement une défaillance d'un transistor à effet de champ, avant l'apparition d'un court-circuit entre source et drain. L'invention porte ainsi sur un dispositif électronique, tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est une représentation schématique d'un premier mode de réalisation d'un dispositif électronique incluant un transistor à effet de champ de puissance et un circuit de détection de court-circuit ;
- les figures 2 et 3 sont des représentations schématiques du comportement électrique du transistor et de son circuit de pilotage, en l'absence et en présence d'un dysfonctionnement ;
- la figure 4 illustre l'évolution de paramètres du transistor de la figure 1 lors de l'apparition d'un court-circuit ;
- la figure 5 illustre schématiquement une variante de circuit de détection ;
- la figure 6 est une représentation schématique d'un deuxième mode de réalisation d'un dispositif électronique incluant deux transistors à effet de champ de puissance connectés en parallèle et un circuit de détection de court-circuit ;
- la figure 7 représente schématiquement des fonctions du circuit de détection de la figure 6 ;
- les figures 8 et 9 illustrent un système incluant un transistor à effet de champ de puissance et son circuit de détection, dans deux conditions de fonctionnement ;
- la figure 10 est une variante du dispositif électronique de la figure 1.

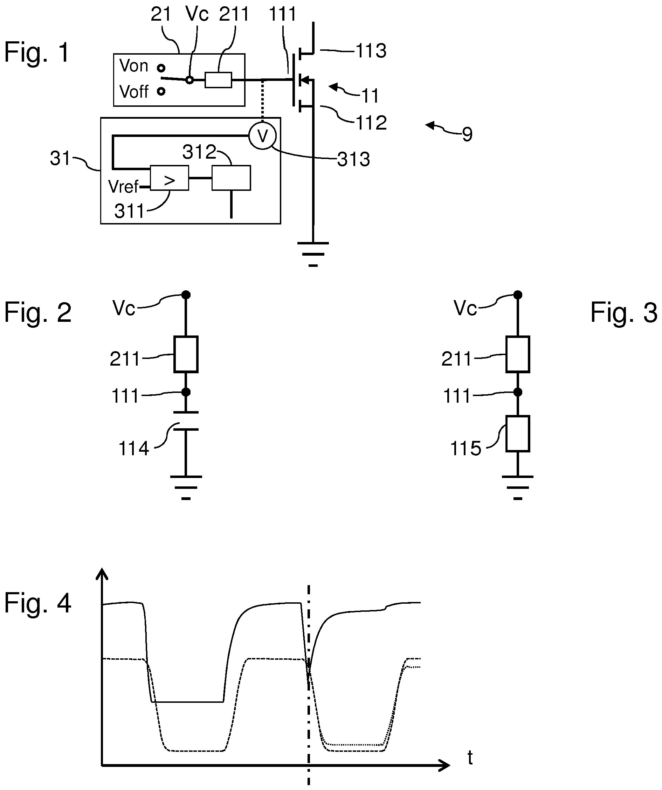

La figure 1 est une représentation schématique d'un dispositif électronique 9 selon un premier mode de réalisation de l'invention. Le dispositif électronique 9 comprend un transistor 11 à effet de champ de puissance, de type normalement ouvert. Un transistor de puissance peut par exemple être conçu pour l'application d'une différence de potentiel entre deux électrodes de conduction au moins égale à 50 V, fréquemment au moins égale à 100 V, et pour être traversé par un courant au moins égal à 5 A, fréquemment au moins égal à 10 A.

Dans cet exemple de mise en oeuvre, le transistor 11 est un transistor MosFET de type N. Le transistor 11 comporte ici de façon connue en soi une grille 111 formant une électrode de commande, une source 112 formant une première électrode de conduction, et un drain 113 formant une seconde électrode de conduction. La source 112 est ici connectée à un potentiel de masse.

Le dispositif électronique 9 comprend également un circuit de pilotage 21 destiné à appliquer un potentiel de commande sur la grille 111 permettant sélectivement d'ouvrir ou de fermer le transistor 11. Le circuit électronique 21 applique ainsi un potentiel sur un noeud Vc prenant soit une valeur Von de fermeture du transistor 11, soit une valeur Voff d'ouverture du transistor 11. Le circuit de pilotage 21 comporte un composant résistif 211 connecté entre le noeud Vc et la grille 111. Le composant résistif 211 est ici purement résistif. De façon connue en soi, le composant résistif 211 peut être inclure deux branches, incluant chacune une diode et une résistance. Les diodes sont alors connectées en antiparallèle. Les résistances de chaque branche peuvent avoir des valeurs différentes pour disposer de vitesses d'ouverture et de fermeture différentes pour le transistor 11.

Le dispositif électronique 9 comprend également un circuit de détection 31 d'un court-circuit entre la source 112 et le drain 113. Le circuit de détection 31 comprend un voltmètre 313, configuré pour mesurer le potentiel de la grille 111 (par exemple par une mesure de différence de potentiel entre grille 111 et source 112). Le circuit de détection 31 comporte également un comparateur 311 et un circuit de traitement 312. Le voltmètre 313 applique le potentiel mesuré sur une entrée du comparateur 311. Le comparateur 311 reçoit par ailleurs une valeur de référence Vref sur une autre entrée. Le comparateur 311 génère un signal de sortie en fonction de la comparaison entre le potentiel mesuré et la valeur de référence Vref. Le circuit de traitement 312 reçoit le signal de sortie du comparateur 311 et génère un signal d'anomalie en fonction du niveau de ce signal de sortie. Le signal d'anomalie peut être utilisé de façon connue en soi pour prévenir des conséquences de l'anomalie détectée, pour par exemple commuter des interrupteurs de sécurité, ouvrir d'autres transistors ou empêcher leur fermeture.

Les inventeurs ont mis en place un simulateur de vieillissement de transistors à effet de champ de puissance de type normalement ouvert, en technologie MosFet. Ces transistors ont été soumis à des cycles de commutation, en l'absence de refroidisseurs afin de provoquer un vieillissement accéléré. Les inventeurs ont étudié les apparitions des défaillances de ces transistors. Les inventeurs ont constaté systématiquement des défaillances initiales sous forme de court-circuit. Les inventeurs ont également constaté que les défaillances intervenaient systématiquement lorsque le transistor était à l'état ouvert ou commutait vers l'état ouvert. Les inventeurs ont également constaté que 99 % des défaillances aboutissaient à une dégradation de l'isolant électrique entre la grille et la source des transistors. Par conséquent, contrairement à un a priori technique de l'homme du métier, l'invention proposée vise à détecter l'apparition d'une défaillance durant l'état bloqué ou ouvert du transistor à effet de champ. Plus précisément, l'invention propose d'anticiper l'apparition d'un court-circuit entre source et drain, en détectant au préalable un courant de fuite anormal entre grille et source.

Usuellement, un transistor à effet de champ est maintenu ouvert en appliquant un potentiel de commande tel que la différence de potentiel entre son électrode de commande et une première électrode de conduction soit nulle, de sorte que cette différence de potentiel soit inférieure à la tension de seuil de ce transistor. Le circuit de pilotage 21 est ici configuré pour appliquer un potentiel Voff sur le noeud Vc inférieur au potentiel des première et deuxième électrodes de conduction 112 et 113. Le circuit de pilotage 21 est donc ici configuré pour obtenir une différence de potentiel négative entre la grille 111 et la source 112 pour le blocage du transistor 11. Le potentiel Voff est par exemple inférieur d'au moins 0,2V par rapport au potentiel de chacune des électrodes de conduction 112 et 113, de préférence inférieur d'au moins 0,5V, voir inférieur d'au moins la valeur de la ta tension seuil.

Pour faciliter la compréhension de l'utilisation d'un tel niveau de potentiel de blocage, les figures 2 et 3 représentent schématiquement le comportement électrique du transistor 11 et de son circuit de pilotage 21, entre le noeud Vc et la source 112. À la figure 2, le transistor 11 est exempt de dysfonctionnement. La structure entre la grille 111 et la source 112 du transistor 11 inclut un isolant électrique et peut être modélisée par un condensateur 114. À la figure 3, le transistor 11 présente un dysfonctionnement, dû à la dégradation de l'isolant électrique entre la grille 111 et la source 112. La structure entre la grille 111 et la source 112 du transistor 11 peut alors être modélisée par une résistance 115. Un pont diviseur de tension est alors formé entre le noeud Vc et la source 112. Dans l'état illustré à la figure 3, du fait de l'application d'une différence de potentiel non nulle entre le noeud Vc et la source 112, la résistance 115 induit une différence entre le potentiel appliqué sur le noeud de commande 21 et le potentiel appliqué sur la grille 111.

Si le potentiel de grille mesuré sur la grille 111 dépasse la valeur Vref, le comparateur 311 fournit un signal de sortie correspondant. Lorsque le circuit de traitement 312 détermine que le potentiel de grille mesuré dépasse la valeur Vref lorsque le transistor 11 est ouvert (et diffère donc du potentiel du noeud de commande 21), il génère un signal d'anomalie. Le circuit de traitement 312 peut prendre en compte d'autres conditions avant de générer un signal d'anomalie, par exemple requérir que le comparateur 311 signale le franchissement de la valeur Vref pendant une durée suffisante, afin d'éviter des déclenchements intempestifs durant des phases transitoires.

Le diagramme de la figure 4 représente d'une part le courant traversant un transistor à effet de champ en trait plein, d'autre part le potentiel de grille de ce transistor, durant plusieurs commutations successives. La courbe en trait discontinu correspond au potentiel de grille du transistor en l'absence de dysfonctionnement. La courbe en pointillés correspond au potentiel de grille du transistor en présence d'un court-circuit. Lors d'une commutation d'ouverture du transistor illustrée sur le diagramme, un court-circuit apparaît et le transistor supposé être ouvert est traversé par un courant. Durant la phase où le circuit de pilotage applique un potentiel d'ouverture sur la grille de ce transistor, le potentiel effectivement appliqué sur la grille est supérieur à ce qu'il devrait être en l'absence de court-circuit, du fait du comportement résistif entre la grille et la source. Ce potentiel de grille anormal est détecté par le circuit de détection du dispositif.

Lors d'une commutation ultérieure de fermeture du transistor, le potentiel de grille est par contre inférieur à ce qu'il devrait être en l'absence de court-circuit.

Un tel dispositif électronique 9 permet d'utiliser un transistor à effet de champ de puissance dans des applications de sécurité, puisqu'on peut détecter de façon extrêmement rapide et fiable l'apparition d'un court-circuit. En outre, la détection est effectuée durant la phase d'ouverture du transistor plutôt que dans les phases de fermeture, ce qui permet de détecter le plus précocement possible le court-circuit, celui-ci apparaissant statistiquement essentiellement durant les phases d'ouverture.

Par ailleurs, la détection est effectuée précocement, avant l'apparition d'un court-circuit entre source et drain. Une détérioration de l'isolant entre grille et source induit en effet un courant de fuite décelable avant l'apparition du court-circuit entre source et drain.

La mesure du potentiel de grille utilisée par l'invention évite des fausses détections qui pourraient être rencontrées en utilisant la différence de potentiel entre les deux électrodes de conduction pour détecter un court-circuit, et permet en outre d'éviter de mesurer une différence de potentiel élevée. La mesure du potentiel de grille utilisée par l'invention s'avère bien moins coûteuse qu'une mesure de courant de grille pour obtenir une détection rapide d'un court-circuit. Par ailleurs, la mesure du potentiel de grille utilisée par l'invention peut être intégrée dans le circuit de pilotage 21.

La valeur de résistance du composant résistif 211 influe sur la sensibilité de la détection de court-circuit. Plus cette résistance de charge est élevée, plus la variation du potentiel de grille lors d'un dysfonctionnement est élevée, et donc plus ce dysfonctionnement est facile à détecter. Par contre, une valeur de résistance élevée ralentit la commutation du transistor. En utilisant deux branches avec des valeurs de résistance différentes comme détaillé auparavant, on peut utiliser une valeur de résistance plus élevée pour la branche destinée à générer l'ouverture du transistor, seule cette ouverture étant alors ralentie.

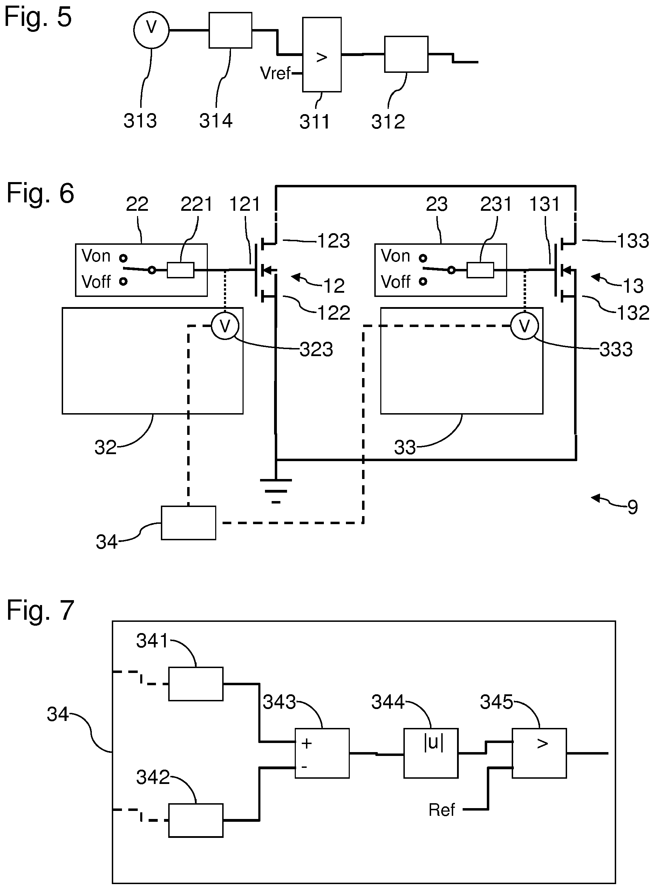

La figure 5 illustre une variante du circuit de détection 31. Dans cette variante, un filtre 314 est interposé entre le voltmètre 313 et le comparateur 311. Ce filtre 314 est destiné à éliminer des pics de tension transitoires, afin d'éviter de fausses détections de court-circuits. Le filtre 314 est par exemple un filtre passe bas. La fréquence de coupure du filtre est alors inférieure à la fréquence équivalente de commutation des transistors et suffisamment basse pour permettre un temps de détection de défaut réduit. Une fréquence de coupure de 500 kHz peut par exemple être utilisée, pour un temps de détection de l'ordre de 10µs.

La figure 6 est une représentation schématique d'un dispositif électronique 9 selon un deuxième mode de réalisation de l'invention. Le dispositif électronique 9 comprend un transistor 12 et un transistor 13, à effet de champ de puissance et de type normalement ouvert. Les transistors 12 et 13 présentent ici une structure identique au transistor 11 de la figure 1. Les transistors 12 et 13 sont connectés en parallèle, leurs sources respectives 122 et 132 étant connectées à un même potentiel et leurs drains respectifs 123 et 133 étant connectés à un même potentiel.

Le dispositif électronique 9 comprend en outre un circuit de pilotage 22 pour appliquer un potentiel de commande sur la grille 121 du transistor 12, et un circuit de pilotage 23 pour appliquer un potentiel de commande sur la grille 131 du transistor 13. Les circuits de commande 22 et 23 sont synchronisés pour appliquer simultanément un potentiel d'ouverture Voff ou de fermeture Von sur des noeuds respectifs Vc. Les circuits de pilotage 22 et 23 comportent respectivement des composants résistifs 221 et 231 connectés entre les grilles 121 et 131 et les noeuds Vc. Les circuits de pilotage 22 et 23 peuvent bien entendu être remplacés par un unique circuit de pilotage.

Le dispositif électronique 9 comprend également un circuit de mesure 32 comportant un voltmètre 323 destiné à mesurer le potentiel de la grille 121, et un circuit de mesure 33 comportant un voltmètre 333 destiné à mesurer le potentiel de la grille 131. Le dispositif électronique 9 comporte en outre un circuit de détection 34 recevant les potentiels mesurés respectivement par les voltmètres 323 et 333.

La figure 7 représente schématiquement différentes fonctions d'un exemple de circuit de détection 34 du dispositif électronique 9 de la figure 6. Le circuit de détection 34 comporte ici un circuit de filtrage 341 sur l'entrée duquel le potentiel mesuré par le voltmètre 323 est appliqué, et un circuit de filtrage 342 sur l'entrée duquel le potentiel mesuré par le voltmètre 333 est appliqué. Les circuits de filtrage 341 et 342 sont destinés à éliminer des pics transitoires de tension pouvant être à l'origine de fausses détections intempestives. Le circuit de détection 34 comporte en outre un circuit 343 recevant en entrée les potentiels filtrés par les filtres 341 et 342. Le circuit 343 fournit en sortie la différence entre ces potentiels filtrés. Le circuit 344 a pour fonction de fournir sur sa sortie la valeur absolue de la différence entre les potentiels filtrés. La valeur absolue de la différence est appliquée sur une première entrée d'un comparateur 345. Une valeur de seuil Ref est appliquée sur une autre entrée du comparateur 345. Lorsque la valeur absolue de la différence dépasse le seuil Ref, la sortie du comparateur 345 génère un signal d'anomalie.

Ainsi, selon ce deuxième mode de réalisation, on estime extrêmement faible la probabilité que les transistors 12 et 13 aient une défaillance en court-circuit en simultané. Par conséquent, le potentiel de grille du transistor non défaillant sert de référence de comparaison pour détecter un potentiel de grille anormal du transistor en court-circuit. On peut noter que lorsqu'un de ces transistors est détruit, il protège l'autre car tout le courant transite par lui.

Ce deuxième mode de réalisation permet notamment de réaliser une détection de court-circuit fiable en s'affranchissant des dispersions entre les transistors et des dispersions liées au vieillissement de tels transistors.

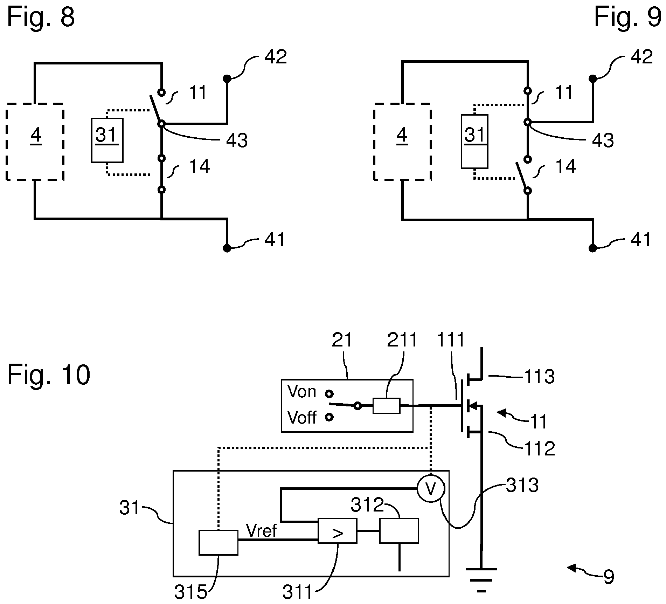

Les figures 8 et 9 illustrent un système incluant un transistor 11 à effet de champ de puissance de type normalement ouvert et son circuit de détection 31. Le système comporte par ailleurs une source de tension continue 4 (telle qu'une batterie d'accumulateurs électrochimiques) et un interrupteur commandé 14, par exemple un transistor à effet de champ de puissance.

Le système comporte deux pôles 41 et 42, et deux branches connectées en parallèle entre les pôles 41 et 42. Une première branche inclut le transistor 11 et la source de tension continue 4 connectés en série. Une deuxième branche inclut l'interrupteur 14, par exemple configuré pour être de type normalement fermé. L'interrupteur 14 et le transistor 11 sont connectés par l'intermédiaire d'un noeud 43.

À la figure 8, le système est dans une configuration de stockage, dans laquelle la borne positive de la source 4 est isolée du pôle 42 par le transistor 11 à l'état ouvert. La borne négative de la source 4 reste connectée au pôle 41. Pour que la différence de potentiel entre les pôles 41 et 42 soit nulle, l'interrupteur 14 est fermé.

À la figure 9, le système est dans une configuration d'alimentation d'une charge électrique. Dans cette configuration, la borne positive de la source 4 est connectée au pôle 42 par le transistor 11 à l'état fermé. Le pôle 42 et le noeud 43 sont isolés du pôle 41 par l'intermédiaire de l'interrupteur 14 à l'état ouvert.

Dans la configuration de la figure 8, le risque est que le transistor 11 connaisse une défaillance en court-circuit, la source de tension continue 4 débitant alors un courant de court-circuit à travers le transistor 11 et l'interrupteur 14 fermé. Pour éviter cela, lorsque le circuit de contrôle 31 détecte l'apparition d'un court-circuit sur le transistor 11, il génère un signal d'anomalie commandant l'ouverture de l'interrupteur 14 ou l'interdiction de la fermeture de cet interrupteur 14. Ainsi, le système peut alors être maintenu dans la configuration de la figure 9, qui permet d'éviter à la source de tension continue 4 de débiter un courant de court-circuit.

Dans le premier mode de réalisation, la valeur Vref peut être variable. La valeur Vref peut alors être fixée de différentes façons. L'exemple de la figure 10 illustre une variante d'un dispositif électronique 9 selon le premier mode de réalisation. Dans cette variante, le dispositif de détection 31 inclut une mémoire tampon 315. La mémoire tampon 315 reçoit un potentiel mesuré par le voltmètre 313 durant une phase d'ouverture du transistor 11. La mémoire tampon 315 applique cette valeur mesurée sur sa sortie avec un décalage temporel. Ainsi, la valeur Vref est définie par une mesure antérieure du potentiel sur la grille 111.

La valeur Vref peut également être générée par l'intermédiaire d'une capacité destinée à modéliser la structure entre la grille 111 et la source 112.

Les composants résistifs 211, 221 et 231 peuvent être mis en oeuvre sous forme de résistances variables. Leur valeur de résistance pourra par exemple être ajustée en fonction de la sensibilité de détection souhaitée, sans sacrifier systématiquement la dynamique de commutation du transistor de puissance.

Dans les exemples détaillés précédemment, le transistor à effet de champ de puissance de type normalement ouvert est un transistor de type MosFET. L'invention s'applique également à tout autre type de transistor à effet de champ de puissance de type normalement ouvert, par exemple en technologie HEMT, IGBT, JFET. Pour l'ensemble de ces types de transistor, une défaillance de l'isolant de l'électrode de commande peut conduire à un court-circuit.

L'invention a été principalement détaillée dans une application à un système incluant une batterie, avec un transistor de puissance de type normalement ouvert utilisé comme interrupteur série pour cette batterie. Cependant, un dispositif électronique selon l'invention peut comporter de nombreuses autres applications, par exemple en connectant de tels transistors dans les bras de pont d'onduleurs, par exemple pour des applications de motorisation électrique.

## Revendications

1. Dispositif électronique (9), comprenant:
- un transistor à effet de champ de puissance (11) de type normalement ouvert, comportant une grille (111), une source et un drain (112, 113) ;
- un circuit de pilotage (21) comportant un composant résistif (211) connecté à la grille, le circuit de pilotage étant configuré pour appliquer un potentiel de blocage du transistor sur la grille par l'intermédiaire du composant résistif, ce potentiel de blocage étant inférieur aux potentiels de la source et du drain ;
- un circuit de détection (31) d'un courant de fuite entre la grille et la source, en vue d'anticiper un court-circuit entre la source et le drain, configuré pour mesurer le potentiel de la grille durant le blocage du transistor, pour comparer le potentiel mesuré à un potentiel de référence, et pour générer un signal d'anomalie en fonction du résultat de la comparaison.

2. Dispositif électronique (9) selon la revendication 1, dans lequel ledit transistor à effet de champ (11) est choisi dans le groupe comprenant les transistors MOSFET, JFET, IGBT et HEMT.

3. Dispositif électronique (9) selon la revendication 1 ou 2, dans lequel ledit composant résistif (211) est une résistance variable.

4. Dispositif électronique selon l'une quelconque des revendications précédentes, dans lequel le circuit de détection génère ledit signal d'anomalie lorsque ledit potentiel mesuré de la grille dépasse le potentiel de référence.

5. Dispositif électronique (9) selon la revendication 4, dans lequel le circuit de détection est configuré pour mémoriser un potentiel de la grille mesuré et configuré pour définir ultérieurement ce potentiel mesuré comme ledit potentiel de référence.

6. Dispositif électronique (9) selon l'une quelconque des revendications 1 à 3, dans lequel ledit transistor à effet de champ de puissance (12) est connecté en parallèle avec un autre transistor à effet de champ de puissance (13) de type normalement ouvert et comportant une grille (131), une source et un drain (132, 133), ledit circuit de détection étant configuré pour mesurer le potentiel de la grille de l'autre transistor durant son blocage, et configuré pour générer ledit signal d'anomalie lorsque la différence entre lesdits potentiels mesurés pour les grilles dépasse un seuil.

7. Dispositif électronique (9) selon l'une quelconque des revendications précédentes, incluant en outre un interrupteur de puissance (14), ledit signal d'anomalie forçant l'ouverture dudit interrupteur de puissance (14).

## Patentansprüche

1. Elektronische Vorrichtung (9), umfassend:
- einen normalerweise offenen Leistungsfeldeffekttransistor (11), umfassend ein Gate (111), eine Source und einen Drain (112, 113);
- eine Ansteuerschaltung (21), die ein Widerstandsbauelement (211) aufweist, das mit dem Gate verbunden ist, wobei die Ansteuerschaltung dazu konfiguriert ist, ein Sperrpotenzial des Transistors über das Widerstandsbauelement an das Gate anzulegen, wobei dieses Sperrpotenzial kleiner als die Potenziale der Source und des Drains ist;
- eine Detektionsschaltung (31) zur Detektion eines Leckstroms zwischen dem Gate und der Source, um einem Kurzschluss zwischen der Source und dem Drain zuvorzukommen, die dazu konfiguriert ist, das Potenzial des Gates während des Sperrens des Transistors zu messen, um das gemessene Potenzial mit einem Bezugspotenzial zu vergleichen und um in Abhängigkeit vom Ergebnis des Vergleichs ein Fehlersignal zu generieren.

2. Elektronische Vorrichtung (9) nach Anspruch 1, bei welcher der Feldeffekttransistor (11) aus der Gruppe gewählt ist, welche die Transistoren MOSFET, JFET, IGBT und HEMT umfasst.

3. Elektronische Vorrichtung (9) nach Anspruch 1 oder 2, bei der das Widerstandsbauelement (211) ein variabler Widerstand ist.

4. Elektronische Vorrichtung nach einem der vorhergehenden Ansprüche, bei der die Detektionsschaltung das Fehlersignal generiert, wenn das gemessene Potenzial des Gates das Bezugspotenzial überschreitet.

5. Elektronische Vorrichtung (9) nach Anspruch 4, bei der die Detektionsschaltung dazu konfiguriert ist, ein gemessenes Potenzial zu speichern, und dazu konfiguriert ist, dieses gemessene Potenzial später als das Bezugspotenzial zu definieren.

6. Elektronische Vorrichtung (9) nach einem der Ansprüche 1 bis 3, bei welcher der Leistungsfeldeffekttransistor (12) parallel zu einem anderen normalerweise offenen Leistungsfeldeffekttransistor (13) geschaltet ist, der ein Gate (131), eine Source und einen Drain (132, 133) umfasst, wobei die Detektionsschaltung dazu konfiguriert ist, das Potenzial des Gates des anderen Transistors während seines Sperrens zu messen, und dazu konfiguriert ist, das Fehlersignal zu generieren, wenn die Differenz zwischen den für die Gates gemessenen Potenzialen einen Schwellenwert überschreitet.

7. Elektronische Vorrichtung (9) nach einem der vorhergehenden Ansprüche, die ferner einen Leistungsschalter (14) beinhaltet, wobei das Fehlersignal das Öffnen des Leistungsschalters (14) erzwingt.

## Claims

1. Electronic device (9), comprising:
- a field effect power transistor (11) of normally open type, comprising a gate (111), a source and a drain (112, 113);
- a control circuit (21) comprising a resistive component (211) connected to the gate, the control circuit being designed to apply a blocking potential of the transistor to the gate by means of the resistive component, this blocking potential being less than the potentials of the source and the drain;
- a detection circuit (31) of a leakage current between the gate and the source, in order to anticipate a short circuit between the source and the drain, designed to measure the potential of the gate during the blocking of the transistor, to compare the measured potential to a reference potential, and to generate an anomaly signal as a function of the result of the comparison.

2. Electronic device (9) according to Claim 1, wherein said field effect transistor (11) is chosen from the group including MOSFET, JFET, IGBT and HEMT transistors.

3. Electronic device (9) according to Claim 1 or 2, wherein said resistive component (211) is a variable resistor.

4. Electronic device according to any one of the preceding claims, wherein the detection circuit generates said anomaly signal when said measured potential of the gate exceeds the reference potential.

5. Electronic device (9) according to Claim 4, wherein the detection circuit is designed to memorize a measured gate potential and designed to then define this measured potential as being said reference potential.

6. Electronic device (9) according to any one of Claims 1 to 3, wherein said field effect power transistor (12) is connected in parallel with another field effect power transistor (13) of normally open type and comprising a gate (131), a source and a drain (132, 133), said detection circuit being designed to measure the gate potential of the other transistor during its blockage, and designed to generate said anomaly signal when the difference between said potentials measured for the gates exceed a threshold.

7. Electronic device (9) according to any one of the preceding claims, including furthermore a power switch (14), said anomaly signal forcing the opening of said power switch (14).
